# EUROPEAN PATENT APPLICATION

(11) **EP 4 847 933 A1**
(43) Date of publication of application: **02.12.2026**
(21) Application number: 25809996.9
(22) Date of filing: 06.03.2025
(51) Int. Cl.: G01R 31/3842, G01R 19/165, G01L 17/00, G01R 31/396

(54) **BATTERY DIAGNOSTIC METHOD AND APPARATUS**

(30) Priority: 10.05.2024 KR 20240062088
(71) Applicant: LG Energy Solution, Ltd., Seoul 07335 (KR)
(72) Inventor: WOO, Kyung-Hwa, Daejeon 34122 (KR); LEE, Jae-Woo, Daejeon 34122 (KR); JEONG, Hee-Seok, Daejeon 34122 (KR)
(74) Representative: Goddar, Heinz J.
(86) International application number: PCT/KR2025/003012
(87) International publication number: WO 2025/234575

(57) **Abstract**

A battery diagnosis method according to an embodiment of the present disclosure includes a measurement information obtaining step of obtaining measurement information on voltage and current of a battery; a side reaction amount calculating step of calculating a side reaction amount generated during a storage period in which the battery is stored in a no-load state based on the measurement information; and a diagnosing step of comparing the calculated side reaction amount with a preset reference amount and diagnosing a state related to a gas amount generated inside the battery based on the comparison result.

## Description

### TECHNICAL FIELD

The present disclosure relates to a battery diagnosis method and apparatus for diagnosing a state of a battery.

This application is based on and claims priority from Korean Patent Application No. 10-2024-0062088, filed on May 10, 2024, with the Korean Intellectual Property Office, the disclosure of which is incorporated herein in its entirety by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although much research is being conducted on these batteries in terms of high capacity and high density, improving lifespan and safety is also important. In order to improve battery safety, a technology that accurately diagnoses the current state of the battery is required.

In particular, internal gas may be generated due to side reactions between the electrode and the electrolyte associated with the movement of operating ions (e.g., lithium ions) while the battery is stored in a no-load state, and the amount of such internal gas generation may vary depending on the degree of side reaction occurrence as well as the degree of deterioration of the positive electrode.

The gas generated inside the battery causes a pressure increase accompanied by an increase in the temperature of the battery. If the gas generated inside the battery increases beyond a certain amount, the battery swells, causing a swelling phenomenon. This external deformation of the battery may cause deformation of the arrangement of the internal stack of the battery or may apply pressure to adjacent equipment, causing damage. Furthermore, if the internal pressure of the battery gradually increases and exceeds a certain pressure, a venting phenomenon occurs. Here, the venting phenomenon refers to a phenomenon in which the surface of the battery is torn or burst, releasing gas. If the swelling phenomenon and/or the venting phenomenon occurs, there is a risk of thermal runaway, in which an internal short circuit occurs and a fire occurs due to high heat. In addition, if the venting phenomenon occurs, there is a risk of a chain reaction in which a fluid flowing in from the outside of the battery reacts with the electrolyte of the battery, causing an explosive increase in the amount of internal gas generated. Therefore, it is necessary to diagnose the state of the battery by monitoring the amount of gas generated inside the battery.

### DISCLOSURE

### Technical Problem

The present disclosure is designed to solve the problems of the related art, and therefore the present disclosure is directed to providing a battery diagnosis method and apparatus that more accurately diagnoses the state related to the amount of gas generated inside the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery diagnosis method according to one aspect of the present disclosure may comprise a measurement information obtaining step of obtaining measurement information on voltage and current of a battery; a side reaction amount calculating step of calculating a side reaction amount generated during a storage period in which the battery is stored in a no-load state based on the measurement information; and a diagnosing step of comparing the calculated side reaction amount with a preset reference amount and diagnosing a state related to a gas amount generated inside the battery based on the comparison result.

The diagnosing step may include a voltage change amount calculating step of calculating a voltage change amount after charging of the battery is completed, when the side reaction amount is greater than or equal to the reference amount; and a first diagnosing step of diagnosing the state of the battery as a normal state or an abnormal state based on the calculated voltage change amount.

The voltage change amount calculating step may be a step of calculating a difference between a first voltage of the battery at a charge completion point of the battery after the storage period and a second voltage of the battery at a point in time when a predetermined period of time has elapsed from the charge completion point as the voltage change amount.

The first diagnosing step may be a step of diagnosing the state of the battery as the normal state when the voltage change amount is less than a preset reference voltage.

The first diagnosing step may be a step of diagnosing the state of the battery as the abnormal state when the voltage change amount is greater than or equal to the reference voltage.

The diagnosing step may include a second diagnosing step of diagnosing the state of the battery as a normal state, when the side reaction amount is less than the reference amount.

The side reaction amount calculating step may be a step of calculating a positive electrode side reaction amount, a negative electrode side reaction amount, or a total side reaction amount of the positive electrode side reaction amount and the negative electrode side reaction amount based on a storage capacity of the battery at a storage start point and a charge capacity after the end of storage.

The side reaction amount calculating step may include a positive electrode side reaction amount calculating step of calculating the positive electrode side reaction amount of the battery based on a first reference capacity of the battery, the storage capacity, and the charge capacity before the storage period.

The positive electrode side reaction amount calculating step may be a step of adding the storage capacity and the charge capacity, and calculating a value obtained by subtracting the first reference capacity from the added result as the positive electrode side reaction amount.

The first reference capacity may be a reference charge capacity preset for the battery for a period prior to the storage period.

The side reaction amount calculating step may include a negative electrode side reaction amount calculating step of calculating the negative electrode side reaction amount of the battery based on the storage capacity, the charge capacity, and a second reference capacity of the battery after the storage period.

The negative electrode side reaction amount calculating step may be a step of adding the storage capacity and the charge capacity, and calculating a value obtained by subtracting the second reference capacity from the added result as the negative electrode side reaction amount.

The negative electrode side reaction amount calculating step may include a negative electrode side reaction amount calculating step of calculating the negative electrode side reaction amount of the battery by further considering a reference charge capacity and a reference discharge capacity of the battery before the storage period.

The negative electrode side reaction amount calculating step may be a step of adding the storage capacity, the charge capacity, and the reference discharge capacity, and calculating a value obtained by subtracting the second reference capacity and the reference charge capacity from the added result as the negative electrode side reaction amount.

A battery diagnosis apparatus according to another aspect of the present disclosure may be configured to perform the battery diagnosis method according to an aspect of the present disclosure.

A battery pack according to still another aspect of the present disclosure may comprise the battery diagnosis apparatus according to one aspect of the present disclosure.

### Advantageous Effects

According to one aspect of the present disclosure, the amount of side reaction occurring in the battery while the battery is stored may be calculated, and the state related to the amount of gas occurring inside the battery may be diagnosed based on the calculated amount of side reaction.

According to one aspect of the present disclosure, the state related to the amount of gas generated inside the battery may be diagnosed more accurately by considering not only the amount of side reactions generated at the positive electrode and/or the negative electrode, but also the amount of voltage change, which is an indicator of the degradation of the positive electrode.

According to one aspect of the present disclosure, there is an advantage in that by appropriately setting the usage conditions of the battery based on the diagnosed state of the battery, acceleration of internal gas generation of the battery may be prevented. Furthermore, there is an advantage in that the occurrence of swelling and venting phenomena of the battery may be delayed.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a flow chart of a battery diagnosis method according to an embodiment of the present disclosure.
FIG. 2 is a diagram schematically illustrating a battery diagnosis apparatus according to an embodiment of the present disclosure.
FIG. 3 is a flow chart that more specifically illustrates a diagnosing step according to an embodiment of the present disclosure.
FIG. 4 is a diagram illustrating the time-series change in the capacity of a battery when the state of the battery is diagnosed according to an embodiment of the present disclosure.

### BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a most preferred example for the purpose of illustrations only, not intended to limit the scope of the disclosure, so it should be understood that other equivalents and modifications could be made thereto without departing from the scope of the disclosure.

In addition, when explaining the present disclosure, if it is judged that the detailed description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

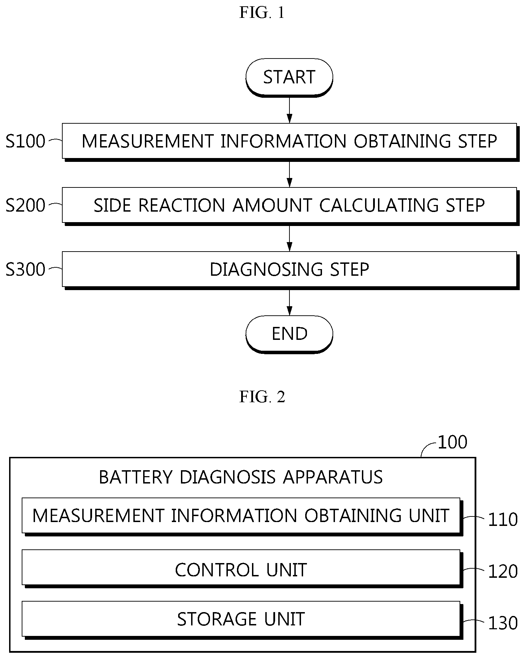

FIG. 1 is a flow chart of a battery diagnosis method according to an embodiment of the present disclosure.

FIG. 2 is a diagram schematically illustrating a battery diagnosis apparatus 100 according to an embodiment of the present disclosure.

Referring to FIG. 1, the battery diagnosis method may include a measurement information obtaining step (S100), a side reaction amount calculating step (S200), and a diagnosing step (S300). Preferably, each step of the battery diagnosis method may be performed by the battery diagnosis apparatus 100.

Referring to FIG. 2, the battery diagnosis apparatus 100 may include a measurement information obtaining unit 110 and a control unit 120. The battery diagnosis apparatus 100 may further include a storage unit 130.

Here, the battery refers to an independent cell that has a negative electrode terminal and a positive electrode terminal and is physically separable. As an example, an operating ion cell or a lithium polymer cell may be considered a battery. Additionally, the type of battery may be cylindrical type, prismatic type, or pouch type. In addition, the battery may mean a battery bank, a battery module, or a battery pack in which a plurality of cells are connected in series and/or parallel. Hereinafter, for convenience of explanation, the battery is explained as meaning one independent cell.

The measurement information obtaining step (S100) is a step of obtaining measurement information on voltage and current of a battery, and may be performed by the measurement information obtaining unit 110.

For example, the measurement information obtaining unit 110 may directly measure the voltage and current of the battery. Specifically, the measurement information obtaining unit 110 may measure the positive electrode voltage and the negative electrode voltage through a pair of voltage sensing lines respectively connected to the positive electrode and the negative electrode of the battery, and measure the voltage across both ends of the battery based on the voltage difference between the measured positive electrode voltage and the negative electrode voltage. The measurement information obtaining unit 110 may be connected to the battery through a current measuring unit to measure the current of the battery. For example, the current measuring unit may be a current sensor or a shunt resistor provided in a charge/discharge path of the battery and capable of measuring the current of the battery. Here, the charge/discharge path of the battery may be a current path through which a charge current is applied to the battery or a discharge current is output from the battery.

As another example, the measurement information obtaining unit 110 may receive measurement information from the outside. That is, the measurement information obtaining unit 110 may receive measurement information by being connected to the outside by wire and/or wirelessly. For example, the measurement information obtaining unit 110 may receive measurement information from the outside using CAN (Controller Area Network) communication, CAN-FD (CAN with Flexible Data rate) communication, etc. As another example, the measurement information obtaining unit 110 may receive measurement information from the outside using Zigbee, Bluetooth, WIFI, or a mobile communication network. Of course, as long as it supports communication between the measurement information obtaining unit 110 and the outside, the type of the communication protocol is not particularly limited.

As another example, the measurement information obtaining unit 110 may receive measurement information from a user or the like through an input means.

The measurement information obtaining unit 110 may be communicatively connected to the control unit 120. The measurement information obtaining unit 110 may be connected to the control unit 120 by wire and/or wirelessly. The measurement information obtaining unit 110 may transmit the obtained measurement information to the control unit 120. The control unit 120 may receive the measurement information from the measurement information obtaining unit 110.

The side reaction amount calculating step (S200) is a step of calculating a side reaction amount that has occurred during the storage period in which the battery is stored in a no-load state based on the measurement information, and may be performed by the control unit 120. Here, the no-load state means a state in which the battery is not charged or discharged by an external device.

Preferably, the storage period may mean a period of time sufficient for a redox reaction (i.e., a side reaction) to occur between the positive electrode and/or negative electrode of the battery and the electrolyte. For example, if the battery is stored for 3 days or more, it may be determined that the battery has been stored for a period of time sufficient for a redox reaction to occur between the positive electrode and/or negative electrode of the battery and the electrolyte.

The side reaction amount calculating step (S200) is a step of calculating a positive electrode side reaction amount, a negative electrode side reaction amount, or a total side reaction amount of the positive electrode side reaction amount and the negative electrode side reaction amount based on the storage capacity of the battery at the storage start point and the charge capacity after the end of storage, and may be performed by the control unit 120.

Here, the side reaction amount is an indicator that quantitatively represents the amount of the positive electrode and/or negative electrode reacted with the electrolyte. The side reaction amount may be the positive electrode side reaction amount, the negative electrode side reaction amount, or the total side reaction amount.

The positive electrode side reaction amount is an indicator that quantitatively represents the side reaction according to the movement of the operating ion between the positive electrode and the electrolyte. Specifically, the positive electrode side reaction (CSR, Cathode Side Reaction) may be defined as a reaction in which the operating ion bound to the electrolyte (solvent) is separated from the electrolyte and moves to the positive electrode. In other words, the reaction in which the operating ion separated from the electrolyte diffuses and is intercalated into the positive electrode active material may be defined as the positive electrode side reaction. As a result of the positive electrode side reaction, the positive electrode obtains the operating ion, and the electrolyte is oxidized to generate gas. For example, a portion of the electrolyte may be oxidized to generate gases such as carbon monoxide (CO) and carbon dioxide (CO₂).

The negative electrode side reaction amount is an indicator that quantitatively represents the side reaction due to the movement of the operating ion between the negative electrode and the electrolyte. Specifically, the negative electrode side reaction (ASR, Anode Side Reaction) may be defined as a reaction in which the operating ion from the negative electrode is bound with the electrolyte. As a result of the negative electrode side reaction, the negative electrode consumes the operating ion, and gas is generated as the operating ion and the electrolyte react. For example, a portion of the electrolyte may be reduced to generate gases such as hydrogen (H₂) and hydrocarbons (CₓH_{y}).

Meanwhile, the gas generated inside the battery causes a pressure increase accompanied by an increase in the temperature of the battery. If the gas generated inside the battery increases beyond a certain amount, a swelling phenomenon occurs in which the battery swells. In addition, if the internal pressure of the battery gradually increases and exceeds a certain pressure, a venting phenomenon occurs. As explained above, the swelling phenomenon and the venting phenomenon are directly related to the battery life and safety, so it is necessary to quantitatively analyze the positive electrode side reaction amount and negative electrode side reaction amount generated inside the battery to determine the amount of internal gas generated.

The specific details of how the control unit 120 calculates the side reaction amount are described later for convenience of explanation.

The diagnosing step (S300) is a step of comparing the calculated side reaction amount with a preset reference amount and diagnosing the state related to the gas amount generated inside the battery based on the comparison result, and may be performed by the control unit 120.

For example, if the calculated side reaction amount is a positive electrode side reaction amount, the control unit 120 may compare a preset positive electrode reference amount with the calculated side reaction amount to correspond to the positive electrode side reaction. Here, the positive electrode reference amount may be preset to a capacity that does not cause a risk of venting or explosion due to gas generated according to the positive electrode side reaction. The positive electrode reference amount may be set differently depending on the composition of the battery.

As another example, if the calculated side reaction amount is a negative electrode side reaction amount, the control unit 120 may compare a preset negative electrode reference amount with the calculated side reaction amount to correspond to the negative electrode side reaction. Here, the negative electrode reference amount may be preset to a capacity that does not cause a risk of venting or explosion due to gas generated according to the negative electrode side reaction. The negative electrode reference amount may be set differently depending on the composition of the battery.

As still another example, if the calculated side reaction amount is a total side reaction amount that is the sum of the positive electrode side reaction amount and the negative electrode side reaction amount, the control unit 120 may compare a preset total reference amount with the calculated side reaction amount to correspond to the total side reaction amount. Here, the total reference amount may be preset to a capacity that does not cause a risk of venting or explosion due to gas generated according to the positive electrode side reaction and the negative electrode side reaction. The total reference amount may be set differently depending on the composition of the battery.

Specifically, the control unit 120 may compare the size of the calculated side reaction amount with the corresponding reference amount. For example, the control unit 120 may compare the size of the calculated side reaction amount with the reference amount. Then, the control unit 120 may diagnose the state of the battery as a normal state or an abnormal state based on the comparison result.

Here, the normal state means a state in which the amount of gas generated inside the battery is small and does not affect the life and safety of the battery. Conversely, the abnormal state means a state in which the amount of gas generated inside the battery is excessive and affects the life and safety of the battery.

Specifically, as explained above, an increase in internal temperature and internal pressure due to internal gas generation in the battery may lead to swelling, venting, or thermal runaway. Such a phenomenon may cause a safety issue when using the battery, and the normal state and abnormal state of the present disclosure are defined as states that take into account the life and safety of the battery due to gas generation.

That is, the normal state may mean a state in which the risk of swelling, venting, or thermal runaway of the battery is low. For example, the normal state may mean a state in which the internal pressure of the battery is maintained at a critical pressure or less. Here, the critical pressure may be set in advance in consideration of the pressure at which the battery may be safely used. For example, the critical pressure may be set to a pressure at which the battery begins to vent. As another example, the critical pressure may be set to a value that is a predetermined pressure lower than the pressure at which the battery begins to vent.

Conversely, the abnormal state may mean a state in which there is a high risk of swelling, venting, or thermal runaway of the battery. For example, it may mean a state in which the internal pressure of the battery exceeds a critical pressure.

According to an embodiment of the present disclosure, there is an advantage in that the state of the battery may be diagnosed based on the amount of side reactions occurring in the battery while the battery is stored in a no-load state.

Meanwhile, the control unit 120 included in the battery diagnosis apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the battery diagnosis apparatus 100 may further include a storage unit 130. The storage unit 130 may store data necessary for operation and function of each component of the battery diagnosis apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Specifically, the storage unit 130 may store information necessary for the control unit 120 to diagnose the state of the battery. For example, the storage unit 130 may store a reference amount, a reference voltage, a discharge end voltage, a charge end voltage, etc. In addition, the control unit 120 may access the storage unit 130 to obtain information necessary for diagnosing the state of the battery.

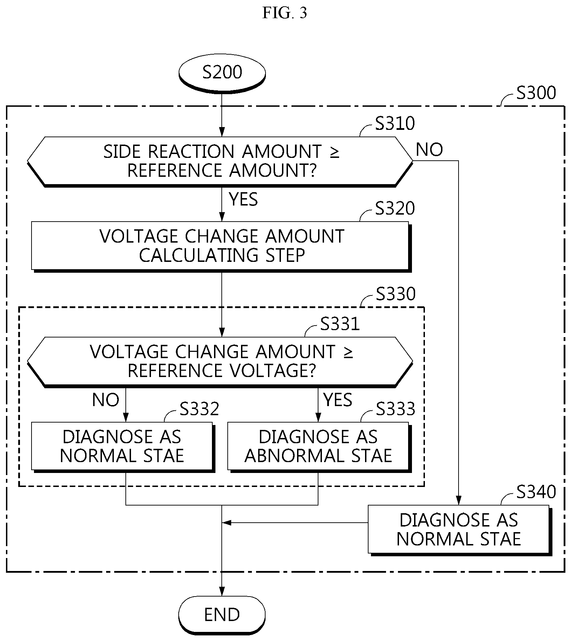

FIG. 3 is a flow chart that more specifically illustrates the diagnosing step (S300) according to an embodiment of the present disclosure. The diagnosing step (S300) may include a comparing step (S310), a voltage change amount calculating step (S320), a first diagnosing step (S330), and a second diagnosing step (S340).

If the comparison result of the comparing step (S310) is YES, the voltage change amount calculating step (S320) may be performed. That is, if the side reaction amount is greater than or equal to the reference amount, the voltage change amount calculating step (S320) may be performed.

Conversely, if the comparison result of the comparing step (S310) is NO, the second diagnosing step (S340) may be performed. That is, if the side reaction amount is less than the reference amount, the second diagnosing step (S340) may be performed.

The voltage change amount calculating step (S320) is a step of calculating the voltage change amount after charging of the battery is completed, if the side reaction amount is greater than or equal to the reference amount, and may be performed by the control unit 120.

The control unit 120 may calculate the difference between the first voltage of the battery at the charge completion point of the battery after the storage period and the second voltage of the battery at a point in time when a predetermined period of time has elapsed from the charge completion point as the voltage change amount.

Specifically, the control unit 120 may receive first voltage information measured at the most recent charge completion point after the storage period from the measurement information obtaining unit 110. The control unit 120 may receive second voltage information measured at a point in time when a predetermined time has elapsed from the first voltage measurement point from the measurement information obtaining unit 110. In addition, the control unit 120 may calculate the difference between the first voltage and the second voltage as the voltage change amount. That is, the control unit 120 may determine a value obtained by subtracting the second voltage from the first voltage as the voltage change amount.

Here, the predetermined time may be set to a time sufficient to allow the overpotential of the battery generated during the charging process to be resolved. For example, the predetermined time may be preset to a time of 10 minutes or more. More preferably, the predetermined time may be preset to a time of between 30 minutes and 1 hour.

Specifically, overpotential occurs due to polarization phenomenon during the charging process, and this overpotential is naturally resolved as charging and discharging are paused. That is, even if an external device does not discharge the battery after charging is completed, the voltage of the battery gradually decreases. For example, the voltage of the battery may gradually decrease and converge to a specific voltage when the overpotential is completely resolved. The control unit 120 may calculate the voltage difference between the first voltage including the overpotential and the second voltage at the point in time when the overpotential is resolved as the voltage change amount.

The first diagnosing step (S330) is a step of diagnosing the state of the battery as a normal state or an abnormal state based on the calculated voltage change amount, and may be performed by the control unit 120. Specifically, if the voltage change amount is less than the preset reference voltage, the control unit 120 may diagnose the state of the battery as a normal state. Conversely, if the voltage change amount is greater than or equal to the reference voltage, the state of the battery may be diagnosed as an abnormal state.

Even if the calculated side reaction amount is greater than or equal to the reference amount, the state of the battery may be diagnosed as a normal state or an abnormal state based on the voltage change amount. That is, if the side reaction amount is greater than or equal to the reference amount, the control unit 120 may diagnose the state of the battery by further considering the voltage change amount. For example, if the side reaction amount is greater than or equal to the reference amount and the voltage change amount is less than the reference voltage, the control unit 120 may diagnose the state of the battery as a normal state. As another example, if the side reaction amount is greater than or equal to the reference amount and the voltage change amount is greater than or equal to the reference voltage, the control unit 120 may diagnose the state of the battery as an abnormal state.

The second diagnosing step (S340) is a step for diagnosing the state of the battery as a normal state if the side reaction amount is less than a reference amount, and may be performed by the control unit 120. That is, if the side reaction amount is less than the reference amount, the control unit 120 may diagnose the state of the battery as a normal state without considering the voltage change amount.

In general, an increase in the side reaction amount accelerates gas generation. Therefore, in the past, the degree of gas generation was diagnosed based only on the side reaction amount. That is, if the side reaction amount is greater than or equal to the reference amount, the state of the battery was diagnosed as an abnormal state. However, even if the side reaction amount is greater than or equal to the reference amount, if the degree of deterioration of the positive electrode is not large, gas generation may not be accelerated. That is, if the side reaction amount is greater than or equal to the reference amount but the degree of deterioration of the positive electrode is not large, the degree of gas generation may not be large. Therefore, in order to more accurately diagnose the state related to the amount of gas generated inside the battery, it is necessary to consider not only the side reaction amount but also the voltage change amount indicating the degree of deterioration of the positive electrode.

The voltage change amount may be used as an indicator indicating the degree of deterioration of the positive electrode. Specifically, the overpotential occurring during the charging process of the battery tends to be larger as the degree of deterioration of the positive electrode increases. Therefore, the degree of deterioration of the positive electrode may be determined by considering the voltage change amount, which is the voltage difference between the first voltage including the overpotential and the second voltage where the overpotential is resolved. For example, the greater the voltage change amount, the greater the degree of deterioration of the positive electrode may be determined. Conversely, the smaller the voltage change amount, the smaller the degree of deterioration of the positive electrode may be determined.

According to an embodiment of the present disclosure, the state of the battery related to the internal gas amount may be diagnosed more accurately by considering not only the side reaction amount occurring at the positive electrode and/or the negative electrode, but also the voltage change amount, which is an indicator of the degradation of the positive electrode.

Hereinafter, a specific example in which the control unit 120 calculates the positive electrode side reaction amount and the negative electrode side reaction amount in step S200 is described.

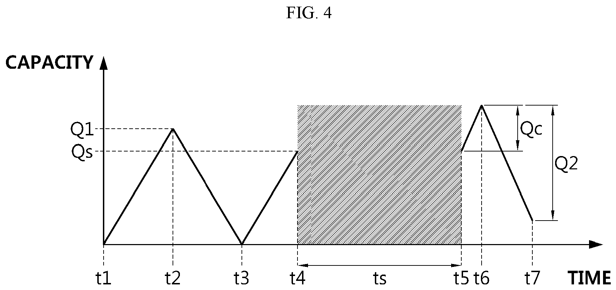

FIG. 4 is a diagram illustrating the time-series change in the capacity of a battery when the state of the battery is diagnosed according to an embodiment of the present disclosure.

Referring to FIG. 4, the time-series change in battery capacity may be confirmed over a period including the storage period (ts).

The side reaction amount calculating step (S200) may include a positive electrode side reaction amount calculating step for calculating the positive electrode side reaction amount of the battery.

The positive electrode side reaction amount calculating step is a step of calculating the positive electrode side reaction amount of the battery based on the first reference capacity (Q1) and the storage capacity (Qs) of the battery before the storage period (ts) and the charge capacity (Qc) after the storage period (ts), and may be performed by the control unit 120.

Specifically, the control unit 120 may add the storage capacity (Qs) and the charge capacity (Qc), and calculate a value obtained by subtracting the first reference capacity (Q1) from the added result as the positive electrode side reaction amount (i.e., Qs + Qc - Q1).

The control unit 120 may determine the storage capacity (Qs) of the battery at the storage start point (t4). For example, the control unit 120 may determine the storage capacity (Qs) based on the voltage of the battery measured at the storage start point (t4). Specifically, the control unit 120 may determine the SOC corresponding to the voltage of the battery measured at the storage start point (t4). The control unit 120 may determine the storage capacity (Qs) based on the determined SOC and the total capacity of the battery. More specifically, the control unit 120 may determine a value obtained by multiplying the determined SOC and the total capacity of the battery as the storage capacity (Qs). For example, the total capacity of the battery may be a measured buffer capacity when the battery is in the BOL (Beginning of Life) state. That is, the total capacity of the battery may be a maximum capacity of the BOL state battery.

The control unit 120 may determine the charge capacity (Qc) after the end of storage. Specifically, the control unit 120 may determine the capacity charged from the storage end point (t5) to the charge end point (t6) as the charge capacity (Qc).

For example, the control unit 120 may calculate the charge capacity (Qc) by accumulating the charge current amount during the charging period (t5 to t6) after the end of storage.

As another example, the control unit 120 may determine the charge capacity (Qc) based on the capacity at the storage end point (t5) and the capacity at the charge end point (t6). The control unit 120 may determine the SOC corresponding to the voltage measured at the storage end point (t5). The control unit 120 may determine the capacity at the storage end point (t5) based on the determined SOC and the total capacity of the preset battery. The control unit 120 may determine a value obtained by multiplying the determined SOC and the capacity of the preset battery as the capacity at the storage end point (t5). The control unit 120 may determine the SOC corresponding to the voltage measured at the charge end point (t6). The control unit 120 may determine the capacity at the charge end point (t6) based on the determined SOC and the capacity of the preset battery. The control unit 120 may determine the capacity at the charge end point (t6) based on the determined SOC and the capacity of the preset battery. And, the control unit 120 may determine the capacity difference between the capacity of the battery at the charge end point (t6) and the capacity of the battery at the storage end point (t5) as the charge capacity (Qc). The control unit 120 may determine a value obtained by subtracting the capacity of the battery at the storage end point (t5) from the capacity of the battery at the charge end point (t6) as the charge capacity (Qc).

The first reference capacity (Q1) may be a preset capacity of the battery for a period prior to the storage period (ts). For example, the first reference capacity (Q1) may be a charge capacity of the battery prior to the storage period (ts). The charge capacity is a capacity calculated when charging of the battery is performed within a preset voltage range (e.g., 2.5 V to 4.2 V). As another example, the first reference capacity (Q1) may be a discharge capacity of the battery prior to the storage period (ts). The discharge capacity is a capacity calculated when discharging of the battery is performed within a preset voltage range. Preferably, the first reference capacity (Q1) may be set to a charge capacity of the battery prior to the storage period (ts).

The side reaction amount calculating step (S200) may include a negative electrode side reaction amount calculating step for calculating negative electrode side reaction amount of the battery.

The negative electrode side reaction amount calculating step is a step of calculating the negative electrode side reaction amount of the battery based on the storage capacity (Qs), the charge capacity (Qc), and the second reference capacity (Q2) of the battery after the storage period (ts), and may be performed by the control unit 120.

Specifically, the control unit 120 may add the storage capacity (Qs) and the charge capacity (Qc), and calculate a value obtained by subtracting the second reference capacity (Q2) from the added result as the negative electrode side reaction amount (i.e., Qs + Qc - Q2).

The control unit 120 may determine the second reference capacity (Q2) based on the capacity of the battery at the charge end point (t6).

For example, the control unit 120 may determine the second reference capacity (Q2) based on the voltage of the battery measured at the charge end point (t6). Specifically, the control unit 120 may determine the SOC corresponding to the voltage measured at the charge end point (t6). The control unit 120 may determine the second reference capacity (Q2) based on the SOC and the total capacity of the battery. More specifically, the control unit 120 may determine a value obtained by multiplying the determined SOC and the total capacity of the battery as the second reference capacity (Q2).

Preferably, the control unit 120 may determine the second reference capacity (Q2) based on the voltage of the battery measured at the charge end point (t6) and the discharge end point (t7). Specifically, the control unit 120 may determine a SOC difference between the SOC corresponding to the voltage measured at the charge end point (t6) and the SOC corresponding to the voltage of the battery measured at the discharge end point (t7). And, the control unit 120 may determine the second reference capacity (Q2) based on the determined SOC difference and the total capacity of the battery. More specifically, the control unit 120 may determine a value obtained by multiplying the determined SOC difference and the total capacity of the battery as the second reference capacity (Q2).

As another example, the control unit 120 may calculate the second reference capacity (Q2) by accumulating the discharge current from the charge end point (t6) until the battery is discharged and the voltage of the battery reaches the lower limit voltage of the preset voltage range (voltage at t7).

Preferably, the preset voltage range may be kept the same whenever the factor used to diagnose the state of the battery according to the present disclosure is calculated. Specifically, the voltage of the battery at t1, t3, and t7 may be set equal to the lower limit voltage of the preset voltage range. The voltage of the battery at t2 and t6 may be set equal to the upper limit voltage of the preset voltage range.

If the voltage of the battery at t4 is within the preset voltage range, the present disclosure may be applied regardless of its size. Meanwhile, when the battery is generally stored at a high SOC, side reactions occur relatively actively. Preferably, the SOC corresponding to the voltage of the battery at t4 may be 70% or more.

According to an embodiment of the present disclosure, the degree of positive electrode side reactions and negative electrode side reactions that occur while the battery is stored in a no-load state may be quantitatively determined based on the capacity of the battery.

The negative electrode side reaction amount calculating step may include a negative electrode side reaction amount calculating step for calculating the negative electrode side reaction amount of the battery by further considering the reference charge capacity (Q11) and the reference discharge capacity (Q12) of the battery before the storage period (ts).

Specifically, the control unit 120 may add the storage capacity (Qs), the charge capacity (Qc), and the reference discharge capacity (Q12), and calculate a value obtained by subtracting the second reference capacity (Q2) and the reference charge capacity (Q11) from the added result as the negative electrode side reaction amount (i.e., Qs + Qc + Q12 - Q2 - Q11).

The reference charge capacity (Q11) may be a capacity set for the battery for a period prior to the storage period (ts). The reference charge capacity (Q11) may be a charge capacity of the battery prior to the storage period (ts). The charge capacity is a capacity calculated when charging of the battery is performed within a preset voltage range.

The reference discharge capacity (Q12) may be a capacity set for the battery for a period prior to the storage period (ts). The reference discharge capacity (Q12) may be a discharge capacity of the battery prior to the storage period (ts). The discharge capacity is a capacity calculated by discharging the battery within the preset voltage range.

According to an embodiment of the present disclosure, the negative electrode side reaction amount may be calculated not only when the reference charge capacity (Q11) and the reference discharge capacity (Q12) are the same, but also when they are different.

A battery diagnosis method according to still another embodiment of the present disclosure may further include a control step for setting a usage condition of the battery according to the state of the battery after the diagnosing step (S300). The control step may be performed by the control unit 120.

Specifically, if the state of the battery is diagnosed as a normal state, the control unit 120 may not change the usage condition of the battery. Conversely, if the state of the battery is diagnosed as an abnormal state, the control unit 120 may change the usage condition of the battery.

Here, the usage condition of the battery may include conditions related to the generation of internal gas of the battery.

For example, the usage condition of the battery may include the upper limit temperature of the battery. In general, the higher the temperature of the battery, the more actively the side reaction between the electrolyte and the electrode tends to occur. That is, the higher the temperature of the battery is stored, the more the internal gas generation rate tends to increase. In particular, the higher the temperature of the battery, the faster the occurrence rate of the negative electrode side reaction in which the operating ion moves from the negative electrode to the electrolyte tends to occur.

Therefore, if the state of the battery is diagnosed as a normal state, the control unit 120 may not change the upper limit temperature of the battery. Conversely, if the state of the battery is diagnosed as an abnormal state, the control unit 120 may reduce the upper limit temperature of the battery.

As another example, the usage condition of the battery may include the upper limit SOC of the battery. In general, the higher the SOC of the battery is stored, the more actively the side reaction between the electrolyte and the electrode tends to occur. In other words, the higher the SOC of the battery is stored, the more the internal gas generation rate tends to increase.

Therefore, if the state of the battery is diagnosed as a normal state, the control unit 120 may not change the upper limit SOC of the battery. Conversely, if the state of the battery is diagnosed as an abnormal state, the control unit 120 may reduce the upper limit SOC of the battery.

According to an embodiment of the present disclosure, there is an advantage in that acceleration of internal gas generation of a battery may be prevented by appropriately setting the usage condition of the battery based on the diagnosed state of the battery. Furthermore, there is an advantage in that unexpected accidents caused by internal gas may be prevented in advance.

The battery diagnosis apparatus 100 according to the present disclosure may be applied to a battery management system (BMS). That is, the BMS according to the present disclosure may include the battery diagnosis apparatus 100 described above. In this configuration, at least some of components of the battery diagnosis apparatus 100 may be implemented by supplementing or adding functions of the components included in a conventional BMS. For example, the measurement information obtaining unit 110, the control unit 120 and the storage unit 130 of the battery diagnosis apparatus 100 may be implemented as components of the BMS.

The battery diagnosis apparatus 100 according to the present disclosure may be provided in the battery pack. That is, the battery pack 10 according to the present disclosure may include the above-described battery diagnosis apparatus 100 and at least one battery cell. Additionally, the battery pack may further include electrical components (relays, fuses, etc.) and a case.

The positive electrode terminal of the battery may be connected to the positive electrode terminal of the battery pack, and the negative electrode terminal of the battery may be connected to the negative electrode terminal of the battery pack.

One end of a load (not shown) may be connected to the positive electrode terminal of the battery pack, and the other end may be connected to the negative electrode terminal of the battery pack. Therefore, the positive electrode terminal of the battery, the positive electrode terminal of the battery pack, the load, the negative electrode terminal of the battery pack, and the negative electrode terminal of the battery may be electrically connected.

For example, the load may be a charging and discharging device, or a motor, etc. of an electric vehicle that receives power from the battery.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### [Explanation of symbols]

100: battery diagnosis apparatus
110: measurement information obtaining unit
120: control unit
130: storage unit

## Claims

1. A battery diagnosis method, comprising:
a measurement information obtaining step of obtaining measurement information on voltage and current of a battery;
a side reaction amount calculating step of calculating a side reaction amount generated during a storage period in which the battery is stored in a no-load state based on the measurement information; and
a diagnosing step of comparing the calculated side reaction amount with a preset reference amount and diagnosing a state related to a gas amount generated inside the battery based on the comparison result.

2. The battery management method according to claim 1,
wherein the diagnosing step includes:
a voltage change amount calculating step of calculating a voltage change amount after charging of the battery is completed, when the side reaction amount is greater than or equal to the reference amount; and
a first diagnosing step of diagnosing the state of the battery as a normal state or an abnormal state based on the calculated voltage change amount.

3. The battery management method according to claim 2,
wherein the voltage change amount calculating step is a step of calculating a difference between a first voltage of the battery at a charge completion point of the battery after the storage period and a second voltage of the battery at a point in time when a predetermined period of time has elapsed from the charge completion point as the voltage change amount.

4. The battery management method according to claim 2,
wherein the first diagnosing step is a step of diagnosing the state of the battery as the normal state when the voltage change amount is less than a preset reference voltage, and diagnosing the state of the battery as the abnormal state when the voltage change amount is greater than or equal to the reference voltage.

5. The battery management method according to claim 1,
wherein the diagnosing step includes a second diagnosing step of diagnosing the state of the battery as a normal state, when the side reaction amount is less than the reference amount.

6. The battery management method according to claim 1,
wherein the side reaction amount calculating step is a step of calculating a positive electrode side reaction amount, a negative electrode side reaction amount, or a total side reaction amount of the positive electrode side reaction amount and the negative electrode side reaction amount based on a storage capacity of the battery at a storage start point and a charge capacity after the end of storage.

7. The battery management method according to claim 6,
wherein the side reaction amount calculating step includes a positive electrode side reaction amount calculating step of calculating the positive electrode side reaction amount of the battery based on a first reference capacity of the battery, the storage capacity, and the charge capacity before the storage period.

8. The battery management method according to claim 7,
wherein the positive electrode side reaction amount calculating step is a step of adding the storage capacity and the charge capacity, and calculating a value obtained by subtracting the first reference capacity from the added result as the positive electrode side reaction amount.

9. The battery management method according to claim 7,
wherein the first reference capacity is a reference charge capacity preset for the battery for a period prior to the storage period.

10. The battery management method according to claim 6,
wherein the side reaction amount calculating step includes a negative electrode side reaction amount calculating step of calculating the negative electrode side reaction amount of the battery based on the storage capacity, the charge capacity, and a second reference capacity of the battery after the storage period.

11. The battery management method according to claim 10,
wherein the negative electrode side reaction amount calculating step is a step of adding the storage capacity and the charge capacity, and calculating a value obtained by subtracting the second reference capacity from the added result as the negative electrode side reaction amount.

12. The battery management method according to claim 10,
wherein the negative electrode side reaction amount calculating step includes a negative electrode side reaction amount calculating step of calculating the negative electrode side reaction amount of the battery by further considering a reference charge capacity and a reference discharge capacity of the battery before the storage period.

13. The battery management method according to claim 12,
wherein the negative electrode side reaction amount calculating step is a step of adding the storage capacity, the charge capacity, and the reference discharge capacity, and calculating a value obtained by subtracting the second reference capacity and the reference charge capacity from the added result as the negative electrode side reaction amount.

14. A battery diagnosis apparatus, configured to perform the battery diagnosis method according to any one of claims 1 to 13.

15. A battery pack, comprising the battery diagnosis apparatus according to claim 14.
